# EUROPEAN PATENT SPECIFICATION

(11) **EP 4 266 826 B1**
(45) Date of publication and mention of the grant of the patent: **29.05.2024**
(21) Application number: 23167227.0
(22) Date of filing: 10.04.2023
(51) Int. Cl.: H05B 3/26, A24F 40/44

(54) **ELECTRONIC ATOMIZATION DEVICE, ATOMIZER, ATOMIZATION CORE, AND PREPARATION METHOD THEREFOR**
ELEKTRONISCHE ZERSTÄUBUNGSVORRICHTUNG, ZERSTÄUBER, ZERSTÄUBUNGSKERN UND HERSTELLUNGSVERFAHREN DAFÜR
DISPOSITIF D'ATOMISATION ÉLECTRONIQUE, ATOMISEUR, NOYAU D'ATOMISATION ET LEUR PROCÉDÉ DE PRÉPARATION

(30) Priority: 20.04.2022 CN 202210418908
(43) Date of publication of application: 25.10.2023
(73) Proprietor: Shenzhen Smoore Technology Limited, Shenzhen Guangdong 518102 (CN)
(72) Inventor: LV, Hongxia, Shenzhen, Guangdong 518102 (CN); LI, Pei, Shenzhen, Guangdong 518102 (CN); JIANG, Zhenlong, Shenzhen, Guangdong 518102 (CN)
(74) Representative: Herrero & Asociados, S.L.

(56) References cited:
- EP-A1- 3 332 657
- EP-A2- 2 892 373
- EP-B1- 2 892 373
- WO-A1-2021/233791
- CN-A- 113 826 962

## Description

### TECHNICAL FIELD

The present disclosure relates to the field of atomizers technologies, and in particular, to an electronic atomization device, an atomizer, an atomization core, and a preparation method for the atomization core.

### BACKGROUND

An electronic atomization device generally includes an atomizer and a power supply assembly. The power supply assembly is configured to supply power to the atomizer. The atomizer in the powered-on state heats and atomizes an aerosol-forming substance to form an aerosol to be inhaled by a user. An atomization core includes a porous substrate and a heating element. In a heating and atomization process of the atomizer, mainly the heating element of the atomization core heats in the powered-on state, so as to heat and atomize the aerosol-forming substance.

Generally, the heating element of the atomization core is a metal heating film layer. However, in the atomization process, the heating element of the atomization core is easy to oxidize and lose efficacy when e-liquid supply is insufficient, which affects product stability and service life.

Document CN 113826962A discloses an atomization core according to the prior art.

### SUMMARY

The present disclosure mainly provides an electronic atomization device, an atomizer, an atomization core, and a preparation method therefor, so as to resolve the technical problem in the related art that a metal heating film layer on an atomization core is prone to failure and has short service life in the atomization process.

In order to resolve the foregoing technical problem, the present disclosure adopts a first technical solution that is as follows. An atomization core is provided, and the atomization core includes a porous substrate, a heating layer, and a protective layer. The porous substrate has an atomization surface; the heating layer is disposed on the atomization surface of the porous substrate; and the protective layer is disposed on the surface of the heating layer away from the porous substrate; where the protective layer includes metallic aluminum and alumina, and the alumina at least partially covers the surface of the metallic aluminum to form an alumina layer.

In some embodiments, the metallic aluminum includes an aluminum film layer and/or aluminum particles.

In some embodiments, the alumina is filled between adjacent aluminum particles, and a plurality of aluminum particles and the alumina are in contact with the heating layer.

In some embodiments, the alumina completely covers the surfaces of the plurality of aluminum particles not in contact with the heating layer.

In some embodiments, the atomization core further includes two electrodes, the electrodes are disposed on the surface of the heating layer away from the porous substrate, and the protective layer and the two electrodes jointly cover the heating layer.

In some embodiments, the thickness of the alumina layer is in the range from 100 nm to 600 nm; and/or the particle diameter of the aluminum particles are in the range from 100 nm to 3 µm; and/or the thickness of the aluminum film layer is in the range from 100 nm to 1 µm.

In some embodiments, the aluminum film layer is a continuous porous structure or a mesh structure; the alumina covers the surface of metallic aluminum to form the alumina layer, and the alumina layer is located on the surface of the side of the aluminum film layer away from the porous substrate.

In some embodiments, the heating layer is made of a titanium zirconium alloy material.

In order to resolve the foregoing technical problem, the present disclosure adopts the second technical solution that is as follows. An atomizer is provided, the atomizer includes a liquid storage cavity configured to store an aerosol-forming substance and any atomization core described above, and the atomization core is configured to heat and atomize the aerosol-forming substance.

In order to resolve the foregoing technical problem, the present disclosure adopts the third technical solution that is as follows. An electronic atomization device is provided, the electronic atomization device includes a power supply assembly and the atomizer described above, and the power supply assembly is configured to provide energy for the atomizer.

In order to resolve the foregoing technical problem, the present disclosure adopts the fourth technical solution that is as follows. A preparation method for an atomization core is provided, including: obtaining a porous substrate on which a heating layer is deposited; depositing metallic aluminum on the surface of the heating layer away from the porous substrate; and oxidizing the metallic aluminum.

In some embodiments, the depositing metallic aluminum on the surface of the heating layer away from the porous substrate specifically includes: depositing metallic aluminum with a thickness in the range from 100 nm to 1 µm on the surface of the heating layer away from the porous substrate.

In some embodiments, the oxidizing the metallic aluminum specifically includes: oxidizing the metallic aluminum for the time in the range from 50 min to 70 min at the air atmosphere and a temperature in the range from 400°C to 700°C.

In some embodiments, the atomization core preparation method further includes: annealing the oxidized metallic aluminum.

The annealing the oxidized metallic aluminum includes: annealing the oxidized metallic aluminum for the range from 6 h to 24 h at the vacuum degree in the range from 0.01 Pa to 100 Pa and the temperature in the range from 650°C to 900°C.

Beneficial effects of the present disclosure are as follows. Different from the related art, the present disclosure discloses an electronic atomization device, an atomizer, an atomization core, and a preparation method therefor. The atomization core includes a porous substrate, a heating layer, and a protective layer; the porous substrate has an atomization surface, the heating layer is disposed on the atomization surface of the porous substrate, the protective layer is disposed on the surface of the heating layer away from the porous substrate, the protective layer includes metallic aluminum and alumina, and the alumina at least partially covers the surface of the metallic aluminum to form an alumina layer. The protective layer is disposed on the surface of the heating layer away from the porous substrate. In the heating and atomization process, the protective layer protects the heating layer, so as to avoid that the heating layer loses efficacy due to oxidation in the atomization process, thereby improving stability of the heating layer, and further increasing the service life of the heating layer.

### BRIEF DESCRIPTION OF THE DRAWINGS

To describe the technical solutions in embodiments of the present disclosure or the related art more clearly, the following briefly describes the accompanying drawings required for describing the embodiments or the related art. Apparently, the accompanying drawings in the following description show only some embodiments of the present disclosure, and a person of ordinary skill in the art may still derive other accompanying drawings from the accompanying drawings without creative efforts.
FIG. 1 is a schematic structural view of an electronic atomization device according to an embodiment of the present disclosure.
FIG. 2 is a schematic structural view of an atomizer in the electronic atomization device as shown in FIG. 1.
FIG. 3 is a schematic structural view of an atomization core as shown in FIG. 2 according to a first embodiment of the present disclosure.
FIG. 4 is a schematic structural view of a top view of the atomization core as shown in FIG. 3.
FIG. 5 is a schematic structural view of an atomization core as shown in FIG. 2 according to a second embodiment of the present disclosure.
FIG. 6 is a schematic structural view of the atomization core as shown in FIG. 5 according to another embodiment of the present disclosure.
FIG. 7 is a schematic structural view of the atomization core as shown in FIG. 5 according to another embodiment of the present disclosure.
FIG. 8 is a schematic flowchart of an atomization core preparation method according to an embodiment of the present disclosure.
FIG. 9 is a schematic structural view of a surface of an operation S3 in the atomization core preparation method as shown in FIG. 8.
FIG. 10 is a schematic flowchart of an atomization core preparation method according to another embodiment of the present disclosure.
FIG. 11 is a schematic structural view of a surface of an operation S4 in the atomization core preparation method as shown in FIG. 10.

### DETAILED DESCRIPTION

The terms "first", "second", and "third" in the embodiments of the present disclosure are merely intended for a purpose of description, and shall not be understood as an indication or implication of relative importance or implicit indication of the number of indicated technical features. Therefore, features defining "first", "second", and "third" can explicitly or implicitly include at least one feature. In description of the present disclosure, "a plurality of" means at least two, such as two and three unless it is specifically defined otherwise. In addition, the terms "include", "have", and any variant thereof are intended to cover a non-exclusive inclusion. For example, a process, method, system, product, or device that includes a series of steps or units is not limited to the listed steps or units; and instead, further optionally includes a step or unit that is not listed, or further optionally includes another step or unit that is intrinsic to the process, method, product, or device.

Embodiment mentioned in the specification means that particular features, structures, or characteristics described with reference to the embodiment may be included in at least one embodiment of the present disclosure. The term appearing at different positions of this specification may not refer to the same embodiment or an independent or alternative embodiment that is mutually exclusive with another embodiment. A person skilled in the art explicitly or implicitly understands that the embodiments described in the specification may be combined with other embodiments.

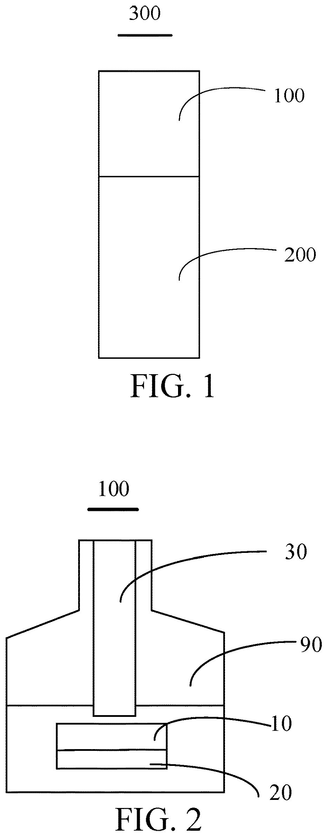

Referring to FIG. 1 and FIG. 2, FIG. 1 is a schematic structural view of an electronic atomization device according to an embodiment of the present disclosure, and FIG. 2 is a schematic structural view of an atomizer in the electronic atomization device as shown in FIG. 1.

Referring to FIG. 1, the present disclosure provides an electronic atomization device 300. The electronic atomization device 300 includes an atomizer 100 and a power supply assembly 200. The power supply assembly 200 is configured to provide energy for the atomizer 100. The atomizer 100 is configured to heat and atomize an aerosol-forming substance in the powered-on state, so as to generate an aerosol to be inhaled by a user.

In some embodiments, the atomizer 100 and the power supply assembly 200 in the electronic atomization device 300 may be of an integral structure, or may be detachably connected, which may be designed according to a specific requirement.

As shown in FIG. 2, the atomizer 100 includes a liquid storage cavity 90, an air outlet pipe 30, an atomization core 10, and an atomization cavity 20 defined in the atomizer 100. The liquid storage cavity 90 is configured to store an aerosol-forming substance, the atomization core 10 is configured to absorb the aerosol-forming substance in the liquid storage cavity 90, and heat and atomize the absorbed aerosol-forming substance, so as to finally generate an aerosol. The aerosol generated by the atomization is in the atomization cavity 20, and the aerosol flows through the air outlet pipe 30 with the external air and finally flows out of the atomizer 100, and may be inhaled by the user.

A heating element of the atomization core is usually a metal heating film layer. Nano particles of the metal heating film layer are easy to oxidize and lose efficacy during a sintering and atomization process, especially when e-liquid supply is insufficient. In the related art, in order to resolve the technical problem that the metal heating film layer is easy to oxidize and lose efficacy, a protective layer formed of noble metal such as gold and platinum is generally disposed on the surface of the metal heating film layer. However, particles such as the gold and platinum are easy to over-burning when there is a few aerosol-forming substance, which causes agglomeration of noble metal particles, and causes the metal heating film layer to be exposed to air, and oxidize and lose efficacy. In addition, the noble metal protective layer has relatively high costs. In view of this, the present disclosure provides an atomization core 10, which is specifically described as follows.

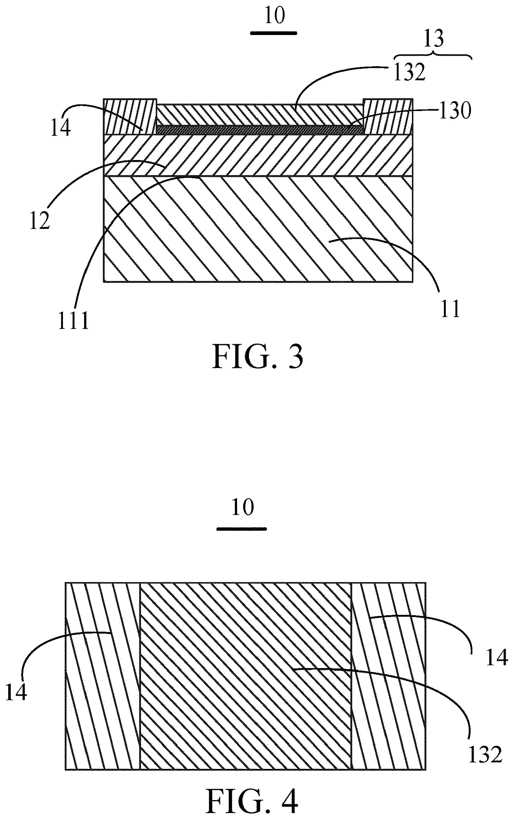

Referring to FIG. 3 and FIG. 4, FIG. 3 is a schematic structural view of the atomization core as shown in FIG. 2 according to a first embodiment of the present disclosure, and FIG. 4 is a schematic structural view of a top view of the atomization core as shown in FIG. 3.

The atomization core 10 includes a porous substrate 11, a heating layer 12, and a protective layer 13, where the porous substrate 11 has an atomization surface 111, the heating layer 12 is disposed on the atomization surface 111 of the porous substrate 11, and the protective layer 13 is disposed on the surface of the side of the heating layer 12 away from the porous substrate 11 and covers the heating layer 12. The protective layer 13 includes metallic aluminum and alumina, and the alumina at least partially covers the surface of the metallic aluminum to form an alumina layer 132. The protective layer 13 is disposed on the surface of the side of the heating layer 12 away from the porous substrate 11, so that it may be possible to reduce the problem that the heating layer 12 losses efficacy due to the oxidation of the heating layer 12 in direct contact with air during the atomization process and the oxidation of the heating layer 12 during the sintering process of the electrode 14. In this case, it may be possible to resolve the problem in the related art that the metal heating film layer is easy to oxidize and lose efficacy during the sintering and atomization process of the electrode, and also resolve the problem in the related art that when a noble metal material is used as the protective layer, and the aerosol-forming substance is insufficient, noble metal particles are easy to cause over-burning and agglomeration, resulting in the failure of the atomization core. Therefore, it may be possible to help improve stability of the atomization core 10 and prolong the service life of the atomization core 10.

Referring to FIG. 3, in this embodiment, the protective layer 13 is disposed on the surface of the heating layer 12 away from the porous substrate 11, and the protective layer 13 includes the metallic aluminum and the alumina, where the metallic aluminum is an aluminum film layer 130, and the aluminum film layer 130 is a continuous porous structure or a mesh structure. The alumina covers the surface of metallic aluminum to form the alumina layer 132. The alumina layer 132 is located on the surface of the side of the aluminum film layer 130 away from the porous substrate 11. The alumina layer 132 is relatively stable, chemically stable, has relatively high melting point and boiling point, and has relatively strong high temperature resistance performance. In the atomization process, even when the aerosol-forming substance in the atomization core 10 is insufficient and over-burning occurs, particle agglomeration due to over-burning does not occur in the protective layer 13, which causes the problem of failure of the atomization core 10. In this way, it may be possible to effectively resolve the foregoing problems in the related art. In addition, compared with the related art in which noble metal materials such as the gold and the platinum are used to prepare the protective layer 13, the metallic aluminum and the alumina are used as materials of the protective layer 13, preparation costs of the protective layer 13 are lower, and thus preparation costs of the atomizer 100 are effectively reduced.

In some embodiments, the protective layer 13 is formed after the metallic aluminum deposited on the surface of the heating layer 12 is oxidized, and the oxidized part of the deposited metallic aluminum forms the alumina layer 132, and the non-oxidized part thereof forms the aluminum film layer 130. The thickness of the alumina layer 132 is in the range from 100 nm to 600 nm, preferably in the range from 100 nm to 300 nm, and more preferably in the range from 180 nm to 220 nm. In this embodiment, the thickness of the alumina layer 132 is 200 nm. It may be understood that, if the thickness of the alumina layer 132 is too small, structural strength of the alumina layer 132 is also lower, and stability of the atomization core 10 is easily reduced. In addition, a barrier capability of the alumina layer 132 to the air or aerosol is also reduced, that is, the protection performance of the alumina layer 132 to the heating layer 12 is weakened, and there is a risk that the heating layer 12 is easy to oxidize and loss efficacy due to air contacts with the heating layer 12, thereby affecting stability and service life of the atomization core 10. If the thickness of the alumina layer 132 is too great, the overall resistance of the atomization core 10 is greatly reduced, thereby affecting the heating efficiency of the atomization core 10. The thickness of the aluminum film layer 130 is 100 nm to 1 µm, and the thickness of the aluminum film layer 130 is related to the oxidation degree, and is negatively related to the thickness of the formed alumina layer 132. That is, the thicker the alumina layer 132, the thinner the aluminum film layer 130.

The shape and the size of the porous substrate 11 are not limited. The porous substrate 11 is made of a material of a porous structure, for example, the porous substrate 11 may be made of porous ceramic, porous glass, porous plastic, or porous metal. In this embodiment, the material of the porous substrate 11 is a porous ceramic substrate. The porous ceramic defines pores, and has functions of liquid guiding and liquid storage, so that the aerosol-forming substance in the liquid storage cavity 90 is absorbed by the porous substrate 11 and penetrates onto the atomization surface 111 to be heated and atomized. In addition, the porous ceramic has a stable chemical property, and does not react with the aerosol-forming substance, and the porous ceramic is resistant to high temperature, and does not deform due to excessive heating temperature during the atomization process. The porous ceramic is an insulator, and is not electrically connected to the heating layer 12 on the surface of the porous ceramic, a short circuit causing failure of the atomization core 10 will not occur. Besides, the porous ceramic is manufactured conveniently and costs thereof are low. In this embodiment, the porous substrate 11 is a rectangular porous ceramic.

In some embodiments, the porosity of the porous ceramic may be in the range from 30% to 70%. The porosity is the ratio of the total volume of small voids in a porous medium to the total volume of the porous medium. The porosity may be adjusted according to the composition of the aerosol-forming substance. For example, when the aerosol-forming substance has a relatively high viscosity, a relatively high porosity is selected to ensure the liquid guiding effect.

In some other embodiments, the porosity of the porous ceramic may be in the range from 50% to 60%. In this way, on the one hand, it may be ensured that the porous ceramic has the better liquid guiding efficiency, so as to prevent the phenomenon of dry burning due to the case that the aerosol-forming substance does not flow smoothly, thereby improving the atomization effect of the atomizer 100. On the other hand, it may be reduced the phenomenon that it is difficult to lock the liquid due to the excessively high porosity of the porous ceramic and excessively fast liquid guiding. In addition, due to the excessively high porosity of the porous ceramic, the probability of leakage increases greatly, and performance of the atomizer 100 is affected.

In another embodiment, when the porous substrate 11 is fabricated by using another porous structure material, for a setting such as the porosity of the porous substrate 11, references may be made to a setting form on the porous ceramic. Details are not described herein again.

It may be understood that when the porous substrate 11 is the porous glass, the porous plastic, or the porous metal, the porous glass, the porous plastic, or the porous metal may be formed by opening holes in a compact glass substrate, plastic substrate, or metal substrate.

When the porous substrate 11 is the porous metal, an insulating layer is disposed between the porous substrate 11 and the heating layer 12, and the insulating layer is configured to insulate the porous substrate 11 from the heating layer 12, so as to reduce a short circuit due to the electrical connection between the porous substrate 11 and the heating layer 12.

The heating layer 12 is disposed on the atomization surface 111 of the porous substrate 11, and is heated in the powered-on state to heat and atomize the aerosol-forming substance. In some embodiments, the heating layer 12 may be at least one of a heating film, a heating coating, a heating line, a heating plate, or a heating mesh. In this embodiment, the heating layer 12 is a porous heating film structure. It may be understood that the porous structure of the heating layer 12 may enable a liquid aerosol-forming substance to penetrate more efficiently to the surface of the heating layer 12 or the atomization surface 111, thereby improving liquid guiding and heat conducting efficiency of the heating layer 12, and improving the atomization effect of the atomization core 10.

A material that may be stably bound to the porous substrate 11 may be selected as the material of the heating layer 12. For example, the heating layer 12 may be made of a material such as titanium, zirconium, titanium aluminum alloy, titanium zirconium alloy, titanium molybdenum alloy, titanium niobium alloy, iron aluminum alloy or tantalum aluminum alloy, or stainless steel.

The titanium and the zirconium have the following features: the titanium and the zirconium are metal with good biocompatibility, especially titanium, which is also a biophilic metal element with relatively high safety. The titanium and the zirconium have a relatively large resistivity in metal materials. In the normal temperature state, alloying of the titanium or the zirconium at a certain ratio has a resistivity three times the original resistivity, and is more suitable for a material that forms the heating layer 12. The titanium and the zirconium have a small thermal expansion coefficient, have a lower thermal expansion coefficient after alloying, and better match with porous ceramics. After alloying at a certain ratio, the melting point of the alloy is lower and the magnetron sputtering coating is better. After metal coating, it can be seen by electron microscope analysis that the microparticles of the metal coating are spherical, and the microparticles coalesce to form a micromorphology similar to cauliflower. It can be seen by electron microscope analysis that the microparticles of the film formed by the titanium zirconium alloy are flake-like, a part of grain boundaries between the particles disappear, and continuity is better. Both titanium and zirconium have good plasticity and elongation, and the titanium zirconium alloy films have better thermal cycle and current impact capability. The titanium is generally used in a stress buffer layer of metal and ceramic, and used as an activated element for ceramic metallization. The titanium reacts with a ceramic interface to form a relatively strong chemical bond, thereby improving adhesion of the film. Based on the foregoing features of the titanium and the zirconium, in this embodiment, the heating layer 12 may be made of a titanium zirconium alloy material.

The thickness of the heating layer 12 is in the range from 0.1 µm to 10 µm. In some embodiments, the thickness of the heating layer 12 may be any specific thickness value of 0.1 µm, 1 µm, 2 µm, 3 µm, 4 µm, 5 µm, 6 µm, 7 µm, 8 µm, 9 µm, or 10 µm. In some embodiments, the thickness of the heating layer 12 is in the range from 2 µm to 5 µm. This thickness can ensure that the thickness of the heating layer 12 matches the pore diameter of the porous substrate 11, prevent the heating layer 12 from blocking a micro-pore of the porous substrate 11 that is used for liquid guiding and liquid storage, thereby improving liquid supply stability in the atomization process of the atomization core 10, and increasing the service life thereof.

In some embodiments, the heating layer 12 may be prepared on the atomization surface 111 of the porous substrate 11 by using a process such as physical vapor deposition or chemical vapor deposition. For example, the heating layer 12 may be prepared by using a process such as sputtering, evaporation coating, atomic layer deposition, or the like. In this embodiment, the heating layer 12 is formed by means of sputtering.

In this embodiment, a titanium zirconium alloy film formed by using a titanium zirconium alloy is a locally compact film. However, since the porous substrate 11 is a porous structure, the titanium zirconium alloy film formed on the surface of the porous substrate 11 also becomes a porous continuous structure, and the pore diameter of the titanium zirconium alloy film is slightly smaller than the micro-pore diameter of the surface of the porous substrate 11.

In this embodiment, as shown in FIG. 3 and FIG. 4, the atomization core 10 further includes two electrodes 14. The two electrodes 14 are electrically connected to the power supply assembly 200 in the electronic atomization device 300, and are configured to supply power to the heating layer 12 in the atomization core 10, so that the heating layer 12 heats in the powered-on state, and the aerosol-forming substance absorbed in the porous substrate 11 is heated and atomized to generate the aerosol.

In some embodiments, both the two electrodes 14 are disposed on the surface of the side of the heating layer 12 away from the porous substrate 11, and are respectively located on the two sides of the protective layer 13, and the protective layer 13 covers a part of the heating layer 12 that is not covered by the two electrodes 14, so as to ensure that the heating layer 12 is completely covered by the protective layer 13 and the two electrodes 14, and cannot be oxidized due to the heating layer 12 is in contact with the air during the atomization process, thereby reducing the problem that the heating layer 12 fails due to the oxidation, thereby improving stability of the atomization core 10, and prolonging the service life of the atomization core 10.

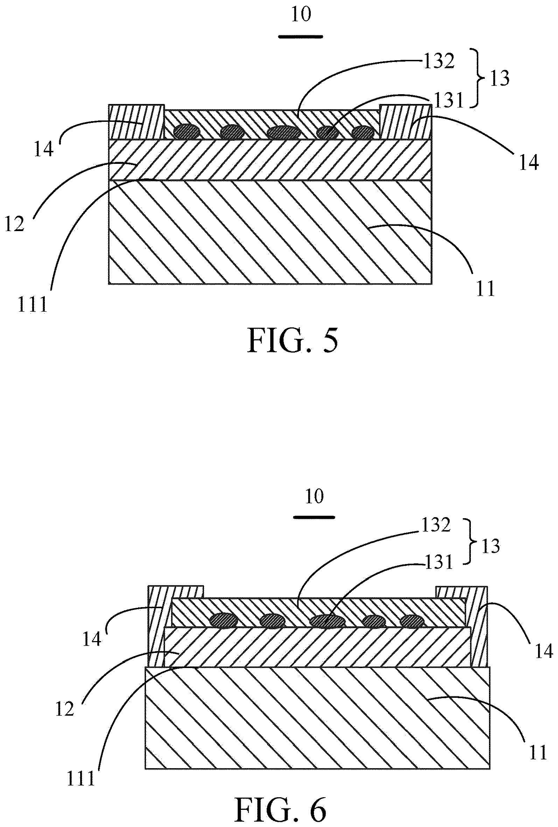

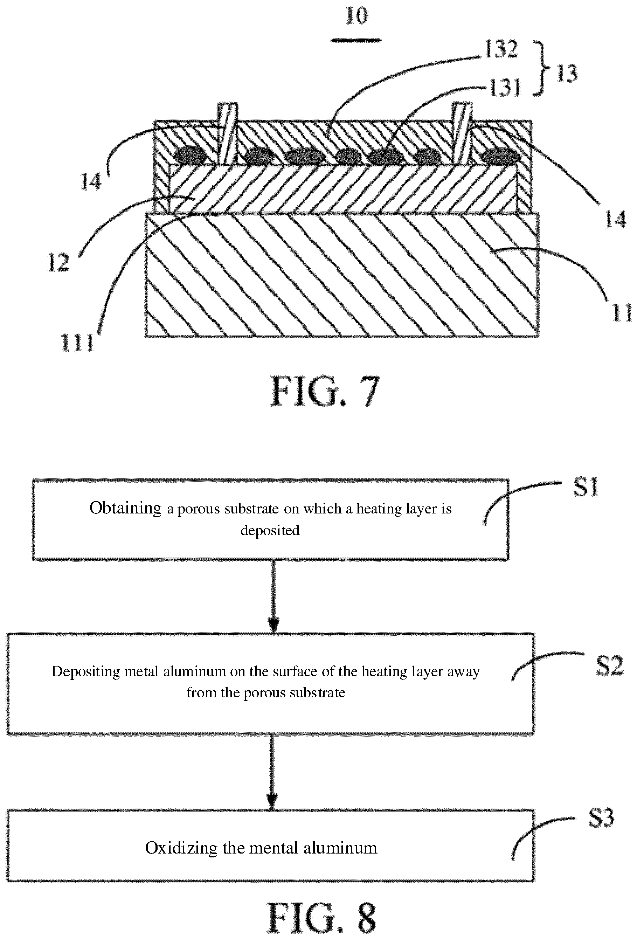

Referring to FIG. 5 to FIG. 7, FIG. 5 is a schematic structural view of an atomization core as shown in FIG. 2 according to a second embodiment of the present disclosure, FIG. 6 is a schematic structural view of the atomization core as shown in FIG. 5 according to another embodiment of the present disclosure, and FIG. 7 is a schematic structural view of the atomization core as shown in FIG. 5 according to another embodiment of the present disclosure.

Referring to FIG. 5, in this embodiment, the structure of the protective layer 13 in the atomization core 10 is different from the structure of the protective layer 13 in the first embodiment of the atomization core 10, and other structures of the atomization core 10 are the same as the structures of the atomization core 10 in the first embodiment. Details are not described herein again.

In this embodiment, the protective layer 13 includes metallic aluminum and alumina, where the metallic aluminum includes a plurality of aluminum particles 131. That is, the protective layer 13 includes the plurality of aluminum particles 131 and an alumina layer 132. In some embodiments, the plurality of aluminum particles 131 may be a plurality of granular structures formed by agglomeration of the aluminum film layer 130 shown in FIG. 3 after the high-temperature annealing process, and the alumina layer 132 is located on the side of the plurality of aluminum particles 131 away from the porous substrate 11. The particle diameter range of the aluminum particles 131 are in the range from 100 nm to 3 µm. It may be understood that the plurality of aluminum particles 131 are formed by agglomeration of the aluminum film layer 130 in the annealing process, and the particle diameter of the aluminum particles 131 is greater than the thickness of the aluminum film layer 130. The plurality of aluminum particles 131 are disposed at intervals, and alumina is filled between two adjacent aluminum particles 131. The alumina completely covers and wraps the surface of the plurality of aluminum particles 131 which is not in contact with the heating layer 12, that is, the alumina layer 132 and the heating layer 12 jointly wrap the plurality of aluminum particles 131. It may be understood that the material of the alumina layer 132 is an oxide, and an anti-oxidation capability of the alumina layer 132 is relatively strong. When the alumina layer 132 is in contact with air in the atomization process, oxidation reaction does not easily occur, and performance of the alumina layer 132 does not change, thereby ensuring stability of the atomization core 10. In addition, the alumina layer 132 has relatively high compactness, and has a relatively strong air barrier capability. The alumina layer 132 completely covers and wraps the plurality of aluminum particles 131, and the two adjacent aluminum particles 131 are filled with the alumina layer 132. Therefore, mutual contact between the plurality of aluminum particles 131 may be prevented from affecting the compactness of the protective layer 13, which may prevent the compactness of the protective layer 13 from affecting the air barrier capability of the protective layer 13, and weakening the protection effect of the protective layer 13 on the heating layer 12, thereby reducing the risk that the air contacts the heating layer 12 and causes oxidation and failure of the heating layer 12.

The aluminum particles 131 have better thermal conductivity, thereby improving electrical conductivity and thermal conductivity of the atomization core 10, so that the alumina layer 132 may also play a role of atomization, so that the heating layer 12 has stronger electrical conductivity and thermal conductivity in the atomization process, and further, atomization efficiency of the atomization core 10 is higher. The plurality of aluminum particles 131 and the alumina layer 132 are in contact with the heating layer 12, so that the heating layer 12 and the alumina layer 132 have better binding property. In addition, the plurality of aluminum particles 131 are in a granular shape, and the coverage area of the alumina layer 132 on the heating layer 12 is increased, so that the protective layer 13 has a stronger protection effect on the heating layer 12.

In addition, the aluminum particles 131 are disposed on the surface of the heating layer 12 and are sintered with the heating layer 12, which is equivalent to that projections disposed at intervals are disposed on the surface of the heating layer 12, which increases the surface area of the heating layer 12 and the area of the alumina layer 132 close to the surface of the heating layer 12. In addition, the plurality of aluminum particles 131 protrude on the surface of the heating layer 12, which helps improve the atomization effect, reduces plane stress, eliminates the possibility that the protective layer 13 breaks in the process of using the atomization core 10, and effectively increases the service life of the atomization core 10.

It may be understood that when the metallic aluminum in FIG. 3 is not completely converted into the aluminum particles 131 in the high-temperature annealing process, the protective layer 13 includes an aluminum film layer 130 (continuous porous structure or mesh structure) and the plurality of aluminum particles 131.

Still referring to FIG. 5, in this embodiment, the structure of the electrode 14 is the same as the structure of the electrode 14 in the first embodiment of the atomization core 10, and details are not described again.

In another embodiment, as shown in FIG. 6, the protective layer 13 is disposed on the surface of the side of the heating layer 12 away from the porous substrate 11, the two electrodes 14 are spaced apart from each other on the surface of the side of the protective layer 13 away from the porous substrate 11, and the two electrodes 14 cover a part of the heating layer 12 that is not covered by the protective layer 13. Both the two electrodes 14 are in contact with the protective layer 13, the heating layer 12, and the porous substrate 11, and both the two electrodes 14 are covered on the side surfaces of the protective layer 13 and the heating layer 12, so that it may be reduce the failure of the atomization core 10 due to the case when the electrodes 14 are disposed on two sides of the protective layer 13, there is a gap between the electrodes 14 and the protective layer 13, and contact between the air and the heating layer 12 cannot be completely separated.

In still another embodiment, as shown in FIG. 7, the protective layer 13 may also completely cover the surface of the heating layer 12 away from the porous substrate 11 and the side surface of the heating layer 12. That is, the protective layer 13 completely wraps the heating layer 12, to completely isolate the heating layer 12 from the air. Two through holes spaced apart from each other (not shown) are provided on the protective layer 13 in a hole opening manner, and the two electrodes 14 are respectively electronically connected to the heating layer 12 through the two through holes defined on the protective layer 13, and the two electrodes 14 are exposed on the surface of the side of the protective layer 13 away from the porous substrate 11, so that the two electrodes 14 may be electrically connected to the power supply assembly 200.

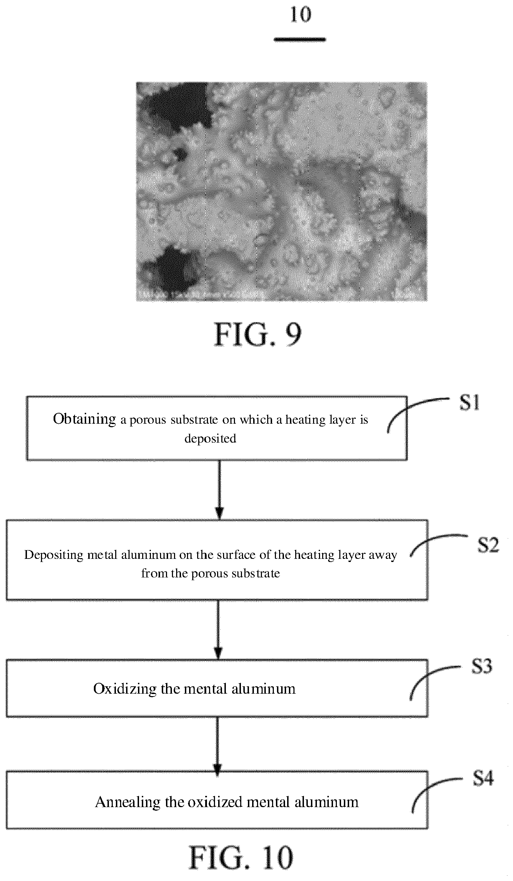

Referring to FIG. 8 and FIG. 9, FIG. 8 is a schematic flowchart of an atomization core preparation method according to an embodiment of the present disclosure, and FIG. 9 is a schematic view of a surface structure of an operation S3 in the atomization core preparation method as shown in FIG. 8.

in some embodiments, the preparation method for the atomization core 10 in the present disclosure includes following operations.

In an operation S1, a porous substrate on which a heating layer is deposited is obtained.

In some embodiments, the porous substrate 11 is made of a material of a porous structure. In this embodiment, the material of the porous substrate 11 is a porous ceramic substrate. In another embodiment, the porous substrate 11 may also be made of porous glass, porous plastic, porous metal, or the like.

The porous substrate 11 has an atomization surface 111, and a heating layer 12 is deposited on the atomization surface 111 of the porous substrate 11, so as to obtain the porous substrate 11 on which the heating layer 12 is deposited. A material that can be stably bound to the porous substrate 11 may be selected as the heating layer 12. For example, the heating layer 12 may be made of a material such as titanium, zirconium, titanium aluminum alloy, titanium zirconium alloy, titanium molybdenum alloy, titanium niobium alloy, iron aluminum alloy or tantalum aluminum alloy, or stainless steel. In this embodiment, the heating layer 12 is made of a titanium zirconium alloy material. The heating layer 12 is prepared on the atomization surface 111 of the porous substrate 11 by means of deposition, and may be prepared by using a process such as physical vapor deposition or chemical vapor deposition. For example, the heating layer 12 may be prepared by using a process such as sputtering, evaporation coating, or atomic layer deposition. In this embodiment, the heating layer 12 is formed on the atomization surface 111 of the porous substrate 11 by using a sputtering process. Then, two electrodes 14 are disposed on the two ends of the heating layer 12 on the surface of the side away from the porous substrate 11, and the two electrodes 14 are spaced apart from each other, and configure to electrically connect to the heating layer 12 and the power supply assembly 200, so as to provide energy for the prepared atomization core 10.

In an operation S2, metallic aluminum on the surface of the heating layer away from the porous substrate is deposited.

In some embodiments, the operation of depositing metallic aluminum on the surface of the heating layer 12 away from the porous substrate 11 as follows may include following operations.

In an operation S21, metallic aluminum with the thickness in the range from 100 nm to 1 µm on the surface of the heating layer 12 away from the porous substrate 11 is deposited.

The metallic aluminum is prepared on the surface of the side of the heating layer 12 away from the porous substrate 11 by means of deposition, and may be prepared by using a process such as physical vapor deposition or chemical vapor deposition. For example, the metallic aluminum may be prepared by using a process such as sputtering, evaporation coating, or atomic layer deposition.

In this embodiment, the metallic aluminum is prepared by using a sputtering process on the surface of the side of the heating layer 12 away from the porous substrate 11. Before the sputtering process is performed on the heating layer 12, masks are disposed on the surfaces of the two electrodes 14 away from the heating layer 12, so as to prevent sputtering of the metallic aluminum onto the two electrodes 14. After sputtering is completed, the masks on the two electrodes 14 are removed. After the sputtering process, on the surface of the side of the heating layer 12 away from the porous substrate 11, the metallic aluminum and the two electrodes 14 completely cover the surface of the side of the heating layer 12 away from the porous substrate 11, where the thickness of the sputtered metallic aluminum is in the range from 100 nm to 1 µm.

In an operation S3, the metallic aluminum is oxidized.

In some embodiments, the metallic aluminum is oxidized for the time in the range from 50 min to 70 min at the air atmosphere and a temperature in the range from 400°C to 700°C.

The metallic aluminum is oxidized in the air atmosphere and a high temperature environment to form an aluminum film layer 130 and an alumina layer 132, to form a protective layer 13 of the atomization core 10 shown in FIG. 3. The alumina layer 132 is located on the side of the aluminum film layer 130 away from the porous substrate 11, because the metallic aluminum is oxidized in the direction from the side away from the porous substrate 11 close to the porous substrate 11. The oxidation process is performed at a temperature in the range from 400°C to 700°C. In the whole oxidation process, the high temperature time is approximately in the range from 50 min to 70 min, and the heating time and the cooling time are approximately in the range from 50 min to 70 min. It may be understood that the thickness of the alumina layer 132 generated on the surface of the metallic aluminum deposited on the surface of the heating layer 12 is obviously related to the duration of the oxidation process and the oxidation temperature. In some embodiments, the longer the oxidation duration is, the higher the sintering temperature is, the more alumina is generated, and the greater the thickness of the alumina layer 132 is. After the oxidation process, the thickness of the alumina layer 132 is in the range from100 nm to 600 nm. In some embodiments, the thickness of the alumina layer 132 is in the range from 100 nm to 300 nm. In some embodiments, when the thickness of the alumina layer 132 is in the range from 180 nm to 200 nm, the atomization effect of the atomization core 10 is stronger. In this embodiment, the thickness of the alumina layer 132 is 200 nm, so as to better protect the heating layer 12.

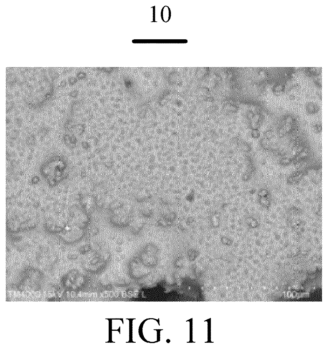

Referring to FIG. 10 and FIG. 11, FIG. 10 is a schematic flowchart of an atomization core preparation method according to another embodiment of the present disclosure, and FIG. 11 is a schematic view of a surface structure of an operation S4 in the atomization core preparation method as shown in FIG. 10.

The preparation method for the atomization core 10 provided in FIG. 10 is different from the preparation method for the atomization core 10 provided in FIG. 8 in the following. After the operation S3, an operation S4 is further included.

In the operation S4, anneal the oxidized metallic aluminum is annealed.

In some embodiments, the oxidized metallic aluminum is annealed for 6 h to 24 h at the vacuum degree of 0.01 Pa to 100 Pa and the temperature of 650°C to 900°C.

After the metallic aluminum deposited on the surface of the heating layer 12 is oxidized, the generated alumina layer 132 and the aluminum film layer 130 are annealed in a high vacuum environment, so that the heating layer 12 and the alumina layer 132 may be better bound. In some embodiments, the annealing process is performed at the vacuum degree of 0.01 Pa to 100 Pa, the annealing temperature is in the range from 650°C to 900°C, and the annealing time is in the range from 6 h to 24 h. After the aluminum film layer 130 and the alumina layer 132 are annealed, the aluminum film layer 130 agglomerates at a high temperature to form the plurality of aluminum particles 131 arranged at intervals, and the particle diameter of each of the aluminum particles 131 is in the range from 100 nm to 3 µm, to form the protective layer 13 of the atomization core 10 shown in FIG. 5. The alumina layer 132 completely covers the plurality of aluminum particles 131, and the alumina layer 132 is filled between adjacent aluminum particles 131. Both the alumina layer 132 and the plurality of aluminum particles 131 are in contact with the heating layer 12. The annealed alumina layer 132 has better bonding with the heating layer 12, thereby improving electrical conductivity and heat conductivity of the heating layer 12, and improving heating efficiency of the atomization core 10. The alumina layer 132 and the plurality of aluminum particles 131 on the surface of the heating layer 12 form the protective layer 13. The protective layer 13 is configured to protect the heating layer 12, so as to prevent the heating layer 12 from being oxidized and failure due to contact with the air, thereby affecting stability and the service life of the atomization core 10. In addition, the heating layer 12 has higher crystallinity after annealed, so that atomization is more uniform, aerosols generated by atomization is increased obviously, and thus atomization efficiency of the atomization core 10 is improved. Since the metallic aluminum is converted into the alumina layer 132 and the aluminum particles 131 during the oxidation and annealing process, the bonding between the alumina layer 132 and the aluminum particles 131 is stronger. Compared with FIG. 9 and FIG. 11, after the annealing process, the crystallinity of the heating layer 12 is increased, the binding between the heating layer 12 and the protective layer 13 is improved, atomization of the atomization core 10 is more uniform, and more aerosols are generated, thereby improving atomization efficiency.

It may be understood that the two electrodes 14 may also be disposed after the metallic aluminum is oxidized and annealed. For example, before the metallic aluminum is deposited on the surface of the heating layer 12 away from the porous substrate 11, two masks spaced apart from each other may be disposed at the two ends on the surface of the heating layer 12 away from the porous substrate 11. The metallic aluminum is deposited at the part of the surface of the heating layer 12 that is not provided with a mask, and then the mask is removed. After the metallic aluminum is oxidized and annealed, the two electrodes 14 are disposed at the position at which the mask is removed, and thus the two electrodes 14 may be electrically connected to the heating layer 12 and the power supply assembly 200. Alternatively, the mask may not be disposed on the surface of the heating layer 12, and the metallic aluminum is directly deposited on the surface of the heating layer 12 away from the porous substrate 11, so that the metallic aluminum completely covers the surface of the heating layer 12. After the metallic aluminum is oxidized and annealed to form a stable protective layer 13, two through holes spaced apart from each other are disposed on the protective layer 13 in a hole opening manner, the two electrodes 14 are electrically connected to the heating layer 12 through the through holes defined on the protective layer 13, and the two electrodes 14 are exposed on the surface of the side of the protective layer 13 away from the porous substrate 11, so as to ensure a stable electrical connection between the two electrodes 14 and the power supply assembly 200.

In this embodiment, by using the foregoing preparation method for the atomization core 10, it may be possible to effectively reduce the failure of the atomization core 10 due to oxidation and agglomeration of noble metal particles, which helps to improve stability and increase the service life of the atomization core 10.

Different from the related art, the present disclosure provides an electronic atomization device, an atomizer, an atomization core, and a preparation method therefor. The atomization core includes a porous substrate, a heating layer, and a protective layer; the porous substrate has an atomization surface, the heating layer is disposed on the atomization surface of the porous substrate, the protective layer is disposed on the surface of the heating layer away from the porous substrate, the protective layer includes metallic aluminum and alumina, and the alumina at least partially covers the surface of the metallic aluminum to form an alumina layer. The protective layer formed of metallic aluminum and alumina is disposed on the surface of the heating layer away from the porous substrate, so that it may be possible to reduce failure of the heating layer on the atomization core due to oxidization when in direct contact with air during the atomization process, thereby improving stability and the service life of the atomization core. In addition, it may be possible to solve the problem of failure of the atomization core caused by over-burning and agglomeration of noble metal particles when the aerosol-forming substance in the atomization core is insufficient and when the noble metal material is used as the protective layer of the heating layer in the related art, and thus the production costs of the atomization core are reduced.

## Claims

1. An atomization core (10) comprising:
a porous substrate (11) having an atomization surface (111);
a heating layer (12), disposed on the atomization surface (111) of the porous substrate (11); and
a protective layer (13), disposed on the surface of the heating layer (12) away from the porous substrate (11); **characterized in that**
the protective layer (13) comprises metallic aluminum and alumina, and the alumina at least partially covers the surface of the metallic aluminum to form an alumina layer (132).

2. The atomization core (10) of claim 1, wherein the metallic aluminum comprises an aluminum film layer (130) and/or aluminum particles (131).

3. The atomization core (10) of claim 2, wherein the alumina is filled between adjacent aluminum particles (131), and a plurality of aluminum particles (131) and the alumina are in contact with the heating layer (12).

4. The atomization core (10) of claim 2, wherein the alumina completely covers the surfaces of plurality of aluminum particles (131) not in contact with the heating layer (12).

5. The atomization core (10) of claim 1, wherein the atomization core (10) further comprises two electrodes (14), the electrodes (14) are disposed on the surface of the heating layer (12) away from the porous substrate (11), and the protective layer (13) and the two electrodes (14) jointly cover the heating layer (12).

6. The atomization core (10) of claim 2, wherein the thickness of the alumina layer (132) is in the range from 100 nm to 600 nm;
and/or the particle diameter of the aluminum particles (131) are in the range from 100 nm to 3 µm;
and/or the thickness of the aluminum film layer (130) is in the range from 100 nm to 1 µm.

7. The atomization core (10) of claim 2, wherein the aluminum film layer (130) is a continuous porous structure or a mesh structure, and the alumina layer (132) is located on the surface of the side of the aluminum film layer (130) away from the porous substrate (11).

8. The atomization core (10) of claim 2, wherein the heating layer (12) (12) is made of a titanium zirconium alloy material.

9. An atomizer (100), **characterized by** comprising:
a liquid storage cavity (90), configured to store an aerosol-forming substance; and
the atomization core (10) according to any one of claims 1 to 8, configured to heat and atomize the aerosol-forming substance.

10. An electronic atomization device (300), **characterized by** comprising:
a power supply assembly (200); and
the atomizer (100) of claim 9, wherein the power supply assembly (200) is configured to provide energy for the atomizer (100).

11. A preparation method for an atomization core according to any one of claims 1 to 8, **characterized by** comprising:
Obtaining (S1) a porous substrate on which a heating layer is deposited;
depositing (S2) metallic aluminum on the surface of the heating layer away from the porous substrate; and
oxidizing (S3) the metallic aluminum.

12. The preparation method for an atomization core of claim 11, wherein the depositing (S2) metallic aluminum on the surface of the heating layer away from the porous substrate comprises:
depositing (S21) metallic aluminum with the thickness in the range from 100 nm to 1 µm on the surface of the heating layer away from the porous substrate.

13. The preparation method for an atomization core of claim 11, wherein the oxidizing (S3) the metallic aluminum comprises:
oxidizing the metallic aluminum for the time in the range from 50 min to 70 min at the air atmosphere and the temperature in the range from 400°C to 700°C.

14. The preparation method for an atomization core of claim 11, wherein the preparation method for an atomization core further comprises: annealing (S4) the oxidized metallic aluminum.

15. The atomization core preparation method of claim 14, wherein the annealing (S4) the oxidized metallic aluminum comprises:
annealing the oxidized metallic aluminum for the range from 6 h to 24 h at the vacuum degree in the range from 0.01 Pa to 100 Pa and the temperature in the range from 650°C to 900°C.

## Patentansprüche

1. Ein Zerstäubungskern (10), der Folgendes umfasst:
Ein poröses Substrat (11) mit einer Zerstäubungsfläche (111);
eine Heizschicht (12), die auf der Zerstäubungsfläche (111) des porösen Substrats (11) aufgebracht ist, und
eine Schutzschicht (13), die auf der Oberfläche der Heizschicht (12) abgewandt vom porösen Substrat (11) aufgebracht ist, **dadurch gekennzeichnet, dass**:
die Schutzschicht (13) ein Aluminiummetall und Aluminiumoxid umfasst und das Aluminiumoxid mindestens die Oberfläche des Aluminiummetalls deckt, um eine Aluminiumoxidschicht (132) zu bilden.

2. Der Zerstäubungskern (10) gemäss Anspruch 1, bei dem das Aluminiummetall eine Aluminiumfilmschicht (130) und/oder Aluminiumteilchen (131) aufweist.

3. Der Zerstäubungskern (10) gemäss Anspruch 2, bei dem das Aluminiumoxid zwischen anliegende Aluminiumteilchen (131) eingefüllt ist, und eine Mehrzahl von Aluminiumteilchen (131) und das Aluminiumoxid mit der Heizschicht (12) im Kontakt stehen.

4. Der Zerstäubungskern (10) gemäss Anspruch 2, bei dem das Aluminiumoxid völlig die Oberflächen einer Mehrzahl von Aluminiumteilchen (131) deckt, die nicht mit der Heizschicht (12) im Kontakt stehen.

5. Der Zerstäubungskern (10) gemäss Anspruch 1, wobei der Zerstäubungskern (10) weiter zwei Elektroden (14) umfasst, die Elektroden (14) an der Oberfläche der Heizschicht (12) sbgewandt vom porösen Substrakt (11) angeordnet sind, und wobei die Schutzschicht (13) und die beiden Elektroden (14) zusammen die Heizschicht(12) bedecken.

6. Der Zerstäubungskern (10) gemäss Anspruch 2, bei dem die Stärke der Aluminiumoxidschicht (132) im Bereich von 100 nm bis 600 nm liegt;
und/oder der Durchmesser der Aluminiumteilchen (131) im Bereich von 100 nm bis 3 µm liegt;
und/oder die Stärke der Aluminiumfilmschicht (130) im Bereich von 100 nm bis 1 µm liegt.

7. Der Zerstäbungskern (10) gemäss Anspruch 2, bei dem die Aluminiumfilmschicht (130) eine fortlaufende poröse Struktur oder eine Maschenstruktur bildet, und die Aluminiumoxidschicht (132) abgewandt vom porösen Substrat (11) auf der Oberfläche der Seite der Aluminiumfilmschicht (130) angeordnet ist.

8. Der Zerstäubungskern (10) gemäss Anspruch 2, bei dem die Heizschicht (12) (12) aus einem Titan-Zirkon-Legierungsmaterial gemacht ist.

9. Ein Zerstäuber (100) **dadurch gekennzeichnet, dass** er Folgendes umfasst:
Einen Hohlraum (90) für Flüssigkeitsspeicherung, der konfiguriert ist, um eine Substanz für die Bildung eines Aerosols zu speichern, und einen Zerstäubungskern (10) gemäss irgendeinem der Ansprüche 1 bis 8, der konfiguriert ist, um die Substanz für die Bildung eines Aerosols aufzuwärmen und zu zerstäuben.

10. Eine elektronische Zerstäubungsvorrichtung (300), **dadurch gekennzeichnet, dass** sie Folgendes umfasst:
Eine Stromversorgungsgruppe (200); und
den Zerstäuber (100) gemäss Anspruch 9, wobei die Stromversorgungsgruppe (200) konfiguriert ist, um den Zerstäuber (100) mit Energie zu versorgen.

11. Eine Zubereitungsmethode für einen Zerstäubungskern gemäss irgendeinem der Ansprüche 1-8, **dadurch gekennzeichnet, dass** sie Folgendes umfasst:
Erhalt (S1) eines porösen Substrats, auf das eine Heizschicht aufgetragen wird;
Ablagerung (S2) von Aluminiummetall auf der Oberfläche der Heizschicht abgewandt vom porösen Substrat; und
Oxidieren (S3) des Aluminiummetalls.

12. Die Zubereitungsmethode für einen Zerstäuberkern gemäss Anspruch 11, bei der die Ablagerung (S2) des Aluminiummetalls auf der Oberfläche der Heizschicht abgewandt vom porösen Substrat Folgendes umfasst:
Ablagerung (S2) von Aluminiummetall mit der Stärke im Bereich von 100 nm bis 1µm auf der Oberfläche der Heizschicht abgewandt vom porösen Substrat.

13. Die Zubereitungsmethode für einen Zerstäuberkern gemäss Anspruch 11, bei der die Oxidierung (S3) des Aluminiummetalls Folgendes umfasst:
Oxidierung des Aluminiummetalls während einer Zeit im Bereich von 50 min bis 70 min unter Luftatmosphäre und bei einer Temperatur im Bereich von 400°C bis 700ºC.

14. Die Zubereitungsmethode für einen Zerstäubungskern gemäss Anspruch 11, wobei die Zubereitungsmethode für einen Zerstäubungskern weiter Folgendes umfasst:
Ausglühen (S4) des oxidierten Aluminiummetalls.

15. Die Zubereitungsmethode für den Zerstäubungskern gemäss Anspruch 14, bei der das Ausglühen (S4) des oxidierten Aluminiummetalls Folgendes umfasst:
Ausglühen des oxidierten Aluminiummetalls in einem Zeitbereich von 6 Std. bis 24 Std. mit einem Vakuumgrad im Bereich von 0,01 Pa bis 100 Pa und der Temperatur im Bereich von 650º C bis 900º C.

## Revendications

1. Un noyau d'atomisation 2. (10) comprenant :
un substrat poreux (11) ayant une surface d'atomisation (111) ;
une couche chauffante (12), disposée sur la surface d'atomisation (111) du substrat poreux (11) ; et
une couche de protection (13), disposée sur la surface de la couche chauffante (12) à l'écart du substrat poreux (11) ; **caractérisée en ce que**
la couche de protection (13) comprend de l'aluminium métallique et de l'alumine, et l'alumine recouvre au moins partiellement la surface de l'aluminium métallique pour former une couche d'alumine (132).

2. Le noyau d'atomisation (10) selon la revendication 1, dans lequel l'aluminium métallique comprend une couche de film d'aluminium (130) et/ou des particules d'aluminium (131).

3. Le noyau d'atomisation (10) selon la revendication 2, dans lequel l'alumine est utilisée pour remplir l'espace entre les particules d'aluminium adjacentes (131), et une pluralité de particules d'aluminium (131) et l'alumine sont en contact avec la couche chauffante (12).

4. Le noyau d'atomisation (10) selon la revendication 2, dans lequel l'alumine recouvre entièrement les surfaces de la pluralité de particules d'aluminium (131) qui ne sont pas en contact avec la couche chauffante (12).

5. Le noyau d'atomisation (10) selon la revendication 1, dans lequel le noyau d'atomisation (10) comprend en outre deux électrodes (14), les électrodes (14) étant disposées sur la surface de la couche chauffante (12) à l'écart du substrat poreux (11), et la couche de protection (13) et les deux électrodes (14) recouvrent conjointement la couche chauffante (12).

6. Le noyau d'atomisation (10) selon la revendication 2, dans lequel l'épaisseur de la couche d'alumine (132) est comprise entre 100 nm et 600 nm ;
et/ou le diamètre des particules d'aluminium (131) est compris dans la plage entre 100 nm et 3 µm ;
et/ou l'épaisseur de la couche de film d'aluminium (130) est comprise dans la plage entre 100 nm et 1 µm.

7. Le noyau d'atomisation (10) selon la revendication 2, dans lequel la couche de film d'aluminium (130) forme une structure poreuse continue ou une structure en treillis, et la couche d'alumine (132) est située sur la surface du côté de la couche de film d'aluminium (130) éloignée du substrat poreux (11).

8. Le noyau d'atomisation (10) selon la revendication 2, dans lequel la couche chauffante (12) (12) est constituée d'un matériau d'alliage de titane et de zirconium.

9. Un atomiseur (100), **caractérisé en ce qu'**il comprend :
une cavité de stockage de liquide (90), configurée pour stocker une substance pour la formation d'un aérosol ; et
le noyau d'atomisation (10) selon l'une quelconque des revendications 1 à 8, configuré pour chauffer et atomiser la substance formant l'aérosol.

10. Dispositif électronique d'atomisation (300), **caractérisé en ce qu'**il comprend :
un bloc d'alimentation électrique (200) ; et
l'atomiseur (100) selon la revendication 9, dans lequel ledit bloc d'alimentation électrique (200) est configuré pour fournir de l'énergie à l'atomiseur (100).

11. Procédé de préparation d'un noyau d'atomisation selon l'une quelconque des revendications 1 à 8, **caractérisé en ce qu'**il comprend :
l'obtention (S1) d'un substrat poreux sur lequel une couche chauffante est déposée ;
le dépôt (S2) d'aluminium métallique sur la surface de la couche chauffante à l'écart du substrat poreux ; et
l'oxydation (S3) de l'aluminium métallique.

12. Procédé de préparation d'un noyau d'atomisation selon la revendication 11, dans lequel le dépôt (S2) d'aluminium métallique sur la surface de la couche chauffante à l'écart du substrat poreux comprend ce que suit :
le dépôt (S21) d'aluminium métallique avec une épaisseur comprise entre 100 nm et 1 µm sur la surface de la couche chauffante à l'écart du substrat poreux.

13. Procédé de préparation d'un noyau d'atomisation selon la revendication 11, dans lequel l'oxydation (S3) de l'aluminium métallique comprend ce que suit :
l'oxydation de l'aluminium métallique pendant une durée comprise entre 50 et 70 minutes sous une atmosphère d'air et à une température comprise entre 400 et 700 °C.

14. Procédé de préparation d'un noyau d'atomisation selon la revendication 11, dans lequel le procédé de préparation d'un noyau d'atomisation comprend en outre ce que suit :
le recuit (S4) de l'aluminium métallique oxydé.

15. Procédé de préparation d'un noyau d'atomisation selon la revendication 14, dans lequel le recuit (S4) de l'aluminium métallique oxydé comprend ce que suit :
le recuit de l'aluminium métallique oxydé pendant un intervalle de 6 h à 24 h sous un degré de vide compris entre 0,01 Pa et 100 Pa et à une température comprise entre 650 °C et 900 °C.
